(19) Europäisches Patentamt
European Patent Office
Office européen des brevets

(11) **EP 4 661 043 A1**

(12) **EUROPEAN PATENT APPLICATION**

(43) Date of publication:
**10.12.2025 Bulletin 2025/50**

(51) International Patent Classification (IPC):
**H01H 11/00** (2006.01) **H01H 59/00** (2006.01)

(21) Application number: **25180580.0**

(52) Cooperative Patent Classification (CPC):
**H01H 59/0009; H01H 11/0062**

(22) Date of filing: **03.06.2025**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **04.06.2024 US 202418733351**

(71) Applicant: **Menlo Microsystems, Inc.**
**Irvine, CA 92618 (US)**

(72) Inventor: **NASSAR, Chris**
**Albany, 12203 (US)**

(74) Representative: **Marks & Clerk LLP**
**15 Fetter Lane**
**London EC4A 1BW (GB)**

(54) **ELECTRICAL MEASUREMENT OF MEMS SWITCH BEAM RESONANT FREQUENCY**

(57) A test circuit structure for determining a resonant frequency of the beam of a micro-electrical-mechanical-system (MEMS) switch includes the MEMS switch having a gate electrode, a switch contact, and the beam. The test circuit structure further includes a voltage supply configured to sequentially produce (i) a switch-close voltage configured to bring the beam in contact with the switch contact, and (ii) a non-zero switch-open voltage configured to release the beam from contact with the switch contact and produce an oscillating current. The test circuit structure further includes a waveform capture device configured to determine the resonant frequency of the beam by an analysis of a waveform produced by the oscillating current upon release of the beam. The waveform generator produces a high voltage to supply the switch-close voltage and produces a low voltage to supply the switch-open voltage.

FIG. 3

**Description**

BACKGROUND

Measurement of second order dynamics, including the resonant frequency, amplitude, phase shift and damping ratio, of a beam in a micro-electromechanical system (MEMS) device is typically done with expensive optical measurement tools, such as laser doppler vibrometers, or even more complex capacitance measurement tools. However, the complexity and expense of these circuits can make them impractical for many applications and may be unsuitable for use in a high-volume production setting. As such, a more cost-effective method of measuring the dynamics of a cantilever beam is required.

SUMMARY

An embodiment is directed toward a micro-electrical-mechanical-system (MEMS) test circuit structure for determining a dynamic of a MEMS switch. The test circuit structure includes the MEMS switch having a gate electrode, a switch contact, and a beam. The test circuit also includes an voltage supply configured to sequentially produce a switch-close voltage configured to bring the beam in contact with the switch contact, and a non-zero switch-open voltage configured to release the beam from contact with the switch contact and produce an oscillating current. In addition, the test circuit includes a waveform capture device configured to determine the dynamic of the MEMS switch by an analysis of a waveform produced by the oscillating current upon beam release.

An embodiment includes a resistor coupled to an output of the beam configured to convert the current to a voltage such that the voltage may be read by the waveform capture device.

In an embodiment, the voltage supply produces a first, high voltage to produce the switch-close voltage and produces a second, low voltage (i.e., lower than the first voltage) to produce the switch-open voltage.

According to an embodiment, the high voltage is 90 volts or higher and the low voltage is 5 volts or lower.

Another embodiment includes a gate driver that induces mechanical resonance in the beam, and provides a constant voltage to the beam while the beam is in motion.

In an embodiment the beam is a cantilever beam.

Another embodiment includes a first cantilever beam comprising a first gate electrode, and a first switch contact, and a second cantilever beam comprising a second gate electrode and a second switch contact. In this embodiment, the voltage supply is configured to sequentially produce the switch close voltage and the switch open voltage to the first cantilever beam and the second cantilever beam. The oscillating current is produced in the first cantilever beam and the second cantilever beam. The waveform capture device is configured to determine the dynamic of the MEMS switch by an analysis of either: (i) a waveform produced by the oscillating current of the first cantilever beam and the second cantilever beam upon beam release, or (ii) an average combined waveform produced by averaging the oscillating current of the first cantilever beam and the second cantilever beam upon beam release.

In an embodiment, a transimpedance amplifier is configured to convert the current into a voltage signal.

In yet another embodiment, the arbitrary waveform generator induces mechanical resonance in the beam and provides a constant voltage to the gate while the beam is in a motion.

In an embodiment, the dynamic of the beam represents the resonant frequency, amplitude, damping ratio, phase shift, or any combination thereof.

Another embodiment is directed toward a method of determining a dynamic of a switch in a MEMS device, the method utilizes a MEMS switch having a gate electrode, a switch contact and a beam. The method is configured to implement any embodiments or combination of embodiments described herein.

Another embodiment is directed toward an apparatus for testing a MEMS switch to determine a dynamic of a beam of the MEMS switch. The apparatus includes a first voltage supply and a second voltage supply, the first voltage supply coupled to a first amplifier configured to set a voltage level, the second voltage supply coupled to a second amplifier configured to set a voltage offset. The method further includes a first amplifier circuit configured to add the voltage level and the voltage offset. The MEMS switch having at least one gate electrode and a beam, the gate electrode is coupled to an output of the first amplifier circuit. The beam is coupled to an input of a second amplifier circuit configured to convert a current to a voltage, an output of the second amplifier circuit is coupled to a waveform capture device configured to determine the dynamic of the MEMS switch. The apparatus is configured to implement any embodiments or combination of embodiments described herein.

BRIEF DESCRIPTION OF THE DRAWINGS

The foregoing will be apparent from the following more particular description of example embodiments, as illustrated in the accompanying drawings in which like reference characters refer to the same parts throughout the different views. The drawings are not necessarily to scale, emphasis instead being placed upon illustrating embodiments.

FIG. 1 is a schematic circuit diagram of the MEMS switch cantilever beam measurement circuit showing the high-level operation, according to an embodiment.

FIG. 2 is a flow diagram showing the measurement of a MEMS switch cantilever beam resonant frequency and damping ratio, according to an embodiment.

FIG. 3 is a schematic block diagram showing a MEMS test circuit structure for determining a resonant frequency of a MEMS switch, according to an embodiment.

FIG. 4 is a schematic diagram of the test circuit structure block diagram from FIG. 3.

FIG. 5 is a view of one embodiment of the circuit of FIG. 1.

FIG. 6 is an oscilloscope readout of the circuit of FIG. 1, according to an embodiment.

FIG. 7 is a readout of the least squares method (LSQ) fits from the oscilloscope data of FIG. 6, according to an embodiment.

DETAILED DESCRIPTION

A description of example embodiments follows.

Disclosed herein is a cost-effective method of measuring the second order dynamics (SOD), i.e., the resonance frequency, amplitude, damping ratio, and phase shift of a cantilever beam MEMS device. Embodiments implement an efficient and scalable test circuit structure to measure the SOD of a cantilever beam in a testing environment. Embodiments disclose a test circuit structure configured to measure the SOD of a micro-electrical-mechanical-system (MEMS) switch cantilever beam.

The embodiment's test circuit structure utilizes the following physical principles. The gate and the beam of the switch form a capacitor whose capacitance is inversely proportional to the distance between the gate and the beam. The beam is positioned over the gate and a high voltage (in some embodiments, 90 volts (V)) is applied to the gate. This applied voltage generates a force which pulls the cantilever beam towards the gate. A low voltage is then applied (2V in an example embodiments) in place of the high voltage which releases the beam from being pulled toward the gate. The release of the beam causes the beam to oscillate upward and downward due to the springboard nature of a cantilever beam being affixed at one end. The subsequent oscillation from the beam being released is then measured. Since a fixed voltage (i.e., 2V) is placed on the gate, and the beam is moving, an electrical current is generated

$$I = V \frac{dc}{dt}$$

according to . A resistor is used to convert the electrical current produced by the moving beam, and the waveform can be visualized with an oscilloscope.

Embodiments provide specific advantages over conventional methods for measuring the resonant frequency and damping ratio of MEMS switch beams. For example, embodiments are simple to implement as they require a small number of components. Further, the measurement process does not damage the MEMS switch nor affect its performance. In addition, embodiments do not rely on light. Meaning, if the switch is packaged or the cantilever beams are covered, the circuit may still perform as desired.

The embodiment's circuit consists of a gate driver configured to both induce the mechanical resonance in the beam and provide the constant gate voltage while the beam is moving. A resistor (or transimpedance amplifier) is used to convert the electrical current to a voltage, and a voltage amplifier is used to drive an oscilloscope allowing for the capture of the resulting wave form.

Typically, measurements like this are done with expensive optical measurement tools such as a laser doppler vibrometer, or more complicated capacitance measuring circuits. Embodiments disclosed herein utilize a simple and cheap alternative to that expensive hardware.

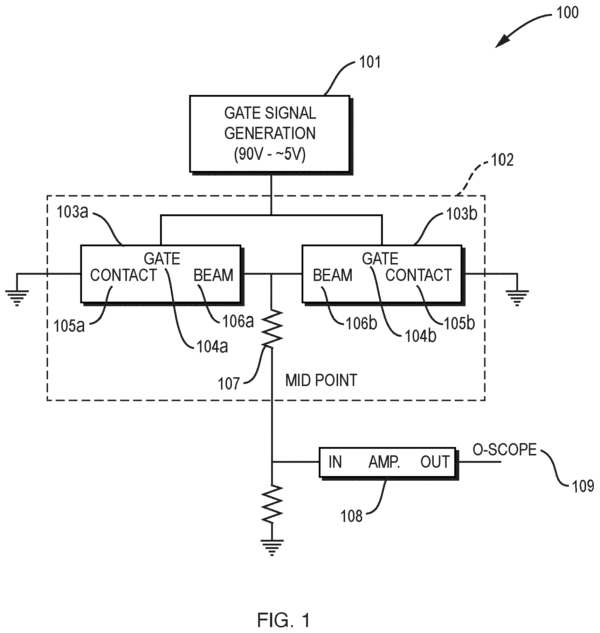

FIG. 1 is a schematic circuit diagram 100 of the MEMS switch beam (i.e., a cantilever beam) measurement circuit, showing the high-level operation. A gate signal configured to close the beam (switch-close voltage) for example, 90 volts (V) or higher, or a gate signal configured to open the beam (switch-open voltage) for example, 5V or lower is provide from the gate signal generation 101, which flows into the circuit 102. The gate signal branches off to two beam circuits 103a-b. The circuits 103a-b comprise a gate contact 104a-b, a ground contact 105a-b and a beam contact 106a-b. The resistor 107 is used to convert the electrical currents generated by the moving beam 103a-b into a voltage signal. The operational amplifier 108 may be used to amplify the voltage signal such that the oscilloscope 109 may be able to read the signal. In this embodiment, the beam to gate capacitance (C) is inversely proportional to the beam position, shown by the equation: $C = \varepsilon A/d$, where $\varepsilon$ is the dielectric electric permittivity of the region between the beam and gate, A is the surface area of the gate, and d is the distance separating the beam and the gate. The governing capacitor circuit equations can be shown by the equations $Q = CV$ (where Q is the amount of charge on the gate or the beam) and

$$I = C \frac{dV}{dt} + V \frac{dc}{dt}$$

(where I is current, C is capacitance and V is voltage) When the device is being switched off, a voltage is left at the gate. The voltage will go from, according to some embodiments 90V to 2V, opposed from 90V to 0V. Since the lower voltage is 2V (or some other small but greater-than-zero voltage), the $V \frac{dc}{dt}$ term in the current (I) equation above will be non-zero while the beam is moving. The least squares fit to damped-mass spring equation is used to extract resonant frequency, the phase shift, and the damping ratio, by the following equation:

$$z(t) = Ae^{-\zeta \omega_0 t} \sin\left(\sqrt{1 - \zeta^2} \omega_0 t + p\right)$$

.

Where $A$ is the amplitude of the signal, $\zeta$ is the damping ratio, $\omega_0$ is the undamped resonant frequency, $t$ is time, and $p$ is the phase shift.

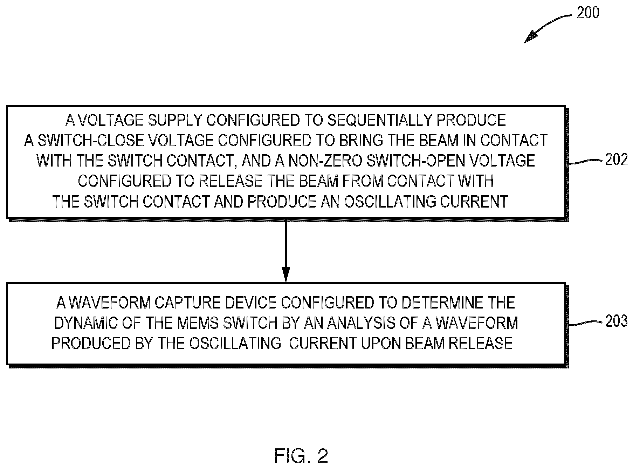

FIG. 2 is a flow diagram 200 for a MEMS test circuit structure for determining a dynamic of a MEMS switch, according to an embodiment. The beam may be, according to an embodiment, one or more cantilever beams. In some embodiments, a gate driver may be used to induce mechanical resonance in the beam and provide a constant voltage to the beam while the beam is in motion.

Still referring to FIG. 2, the test circuit structure also includes a voltage supply 202 configured to sequentially produce a switch-close voltage that will bring the beam in contact with the switch contact, as well as produce a switch-open voltage that will release the beam from contact with the switch contact. In this configuration, since a voltage is still present while the switch is being opened, the gate and the beam form a capacitive relationship relative to the distance between the gate and beam contacts as the beam oscillates. In some embodiments, the voltage supply may produce a high voltage (in some embodiments, 90V or higher) as the switch-close voltage and may produce a low voltage (in some embodiments, 5V or lower) as the switch-open voltage. The voltage supply may be, for example, an arbitrary waveform generator. In addition, in some embodiments the voltage supply may induce a mechanical resonance in the beam and provide a constant voltage to the gate while the beam is in motion. Since a voltage is still applied, the oscillation of the beam release will induce a current into the beam. The waveform produced by the switch-open voltage may approximate a step function. In some embodiments, a resistor may be coupled to the output of the beam and configured to convert the current to a voltage such that the voltage may be read by a waveform capture device. In other embodiments, a transimpedance amplifier may be configured to convert the current into a voltage signal.

Still referring to FIG. 2, a waveform capture device 203 is used to determine the resonant frequency of the MEMS switch by an analysis of a waveform produced by the oscillating current upon beam release. The waveform capture device may save the data it receives, as well as extract important parameters of the second order system, such as the resonant frequency, damping ratio, amplitude, and phase shift. The waveform capture device, such as an oscilloscope, may capture the waveform, but a personal computer may perform the analysis. In some embodiments, the test circuit structure may also include a first cantilever beam including a first gate electrode, and a first switch contact, a second cantilever beam including a second gate electrode and a second switch contact. The voltage supply may be configured to sequentially produce the switch close voltage and the switch open voltage to the first cantilever beam and the second cantilever beam, the oscillating current being produced in the first cantilever beam and the second cantilever beam. The waveform capture device may be configured to determine the dynamics of the MEMS switch by an analysis of a waveform produced by the oscillating current of the first cantilever beam and the second cantilever beam upon beam release. In an embodiment, the waveform presented to the waveform capture device represents the resonant frequency of the beam.

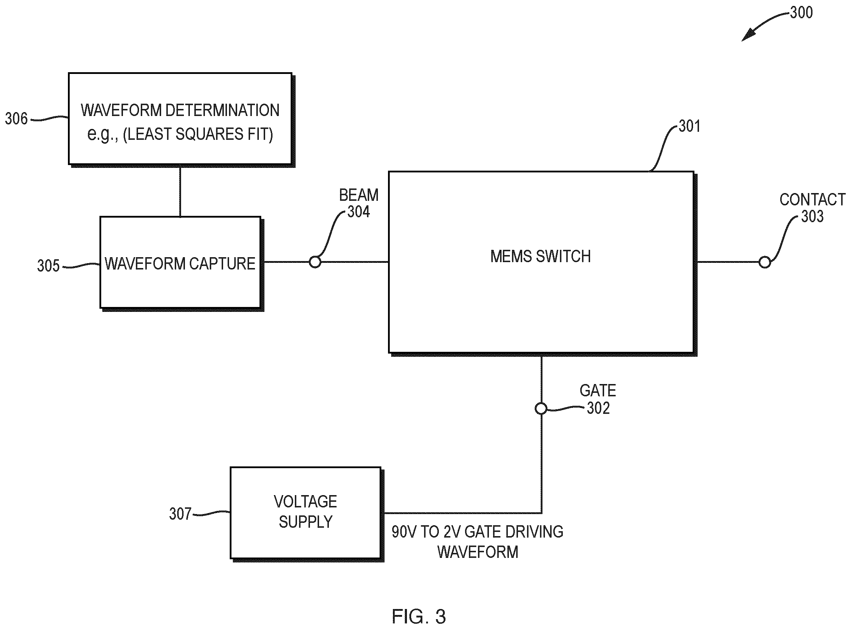

FIG. 3 is a simplified block diagram 300 for an example MEMS test circuit structure for determining dynamics of a MEMS switch. The test circuit houses the MEMS switch 301, the MEMS switch includes a gate 302, a switch contact 303 and a beam 304. The switch contact 303 will be connected to a ground potential. A voltage supply 307 sends a 90V signal the gate 302, which will pull the beam 304 toward the gate 302. The voltage supply 307 will then send a 2V signal (or some other non-zero voltage) to the gate 302, which will release the beam 304 from being in contact with the gate 302. Once the beam 304 is released, the beam 304 will oscillate upward and downward due to the springboard nature of a cantilever beam being affixed at one end. Then, since there is still a voltage (e.g., 2V) applied to the gate 302, and since the beam 304 and the gate 302 form a variable capacitance capacitor, the current through this capacitor can be measured as $I = V\frac{dc}{dt}$. This current I may be converted to a voltage and sent to the waveform capture device 305. The waveform capture device 305 may be, depending on the embodiment, an oscilloscope, or an analog to digital converter (ADC), or any other suitable component capable of receiving and recording the incoming waveform for subsequent analysis. The waveform determination equation 306, which in some embodiments is the least squares fit equation described above, to determine the dynamics of the beam 304 of the MEMS switch 301.

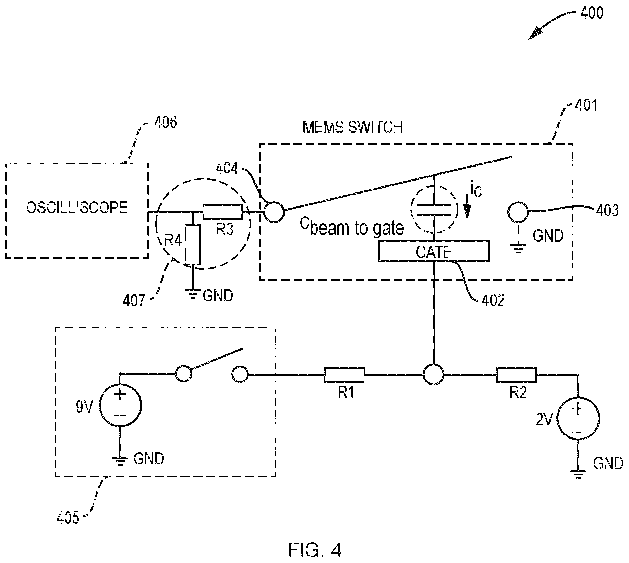

FIG. 4 is an example schematic diagram 400 of the test circuit structure block diagram from FIG. 3. The test circuit hosts the MEMS switch 401, which includes a gate 402, a switch contact 403, and a beam 404. The switch contact 403 is connected to a ground. A voltage supply 405 sends a 90V signal to the gate, which pulls the beam 404 toward the gate 402. The voltage supply 405 will then send a 2V signal to the gate 402, which releases the beam 404 from being in contact with the gate 402. Once the beam 404 is released, the beam 404 will oscillate towards and away from the gate (i.e., cyclically back and forth). Then, since there is still a voltage applied to the gate 402, the beam 404 and the gate 402 form a variable capacitance capacitor, the capacitance of which varies according to the distance between the beam and the gate. and the current of this capacitor can be measured as $I = V\frac{dc}{dt}$. The current from this variable capacitor gets converted to a voltage at the resistor pairing 407 and is sent to the waveform capture device 406, which in some embodiments is an oscilloscope. The waveform determination equation, which in some embodiments is the least squares fit equation described above, to determine the dynamics, such as resonant frequency, amplitude, phase shift or damping ratio of the beam 404 of the MEMS switch.

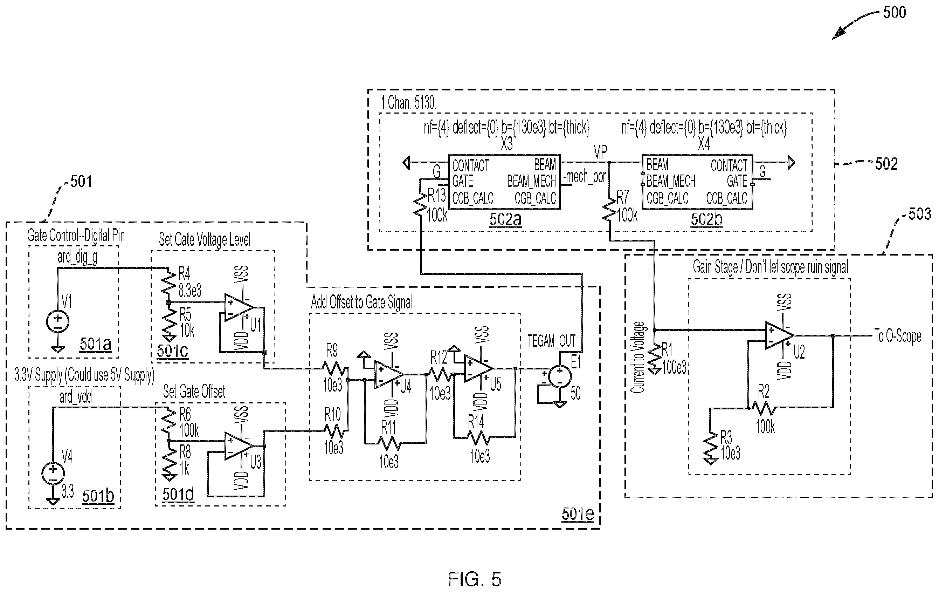

FIG. 5 is a detailed schematic diagram 500 of the circuit diagram 100 from FIG. 1A. Within circuit 501, a first voltage supply 501a is coupled to a first amplifier circuit 501c and configured to set a voltage level. Circuit 501 also contains a second voltage supply 501b and a second amplifier circuit 501d configured to set a voltage offset. The voltage level and the voltage offset are then added together with the amplifier circuit 501e, this new signal is now the gate signal. The gate signal from the circuit 501 flows into the cantilever beam circuit 502, which in this embodiment contains two cantilever beams 502a-b. The current produced from the cantilever beam circuits 502 is converted into a voltage, pushed through an amplifier circuit 503 and sent to a waveform capture device (for example, an oscilloscope) for reading in circuit. Although specific resistor values are shown in FIG. 5, it should be known by a person of ordinary skill in the art that these may be manipulated for any particular purpose.

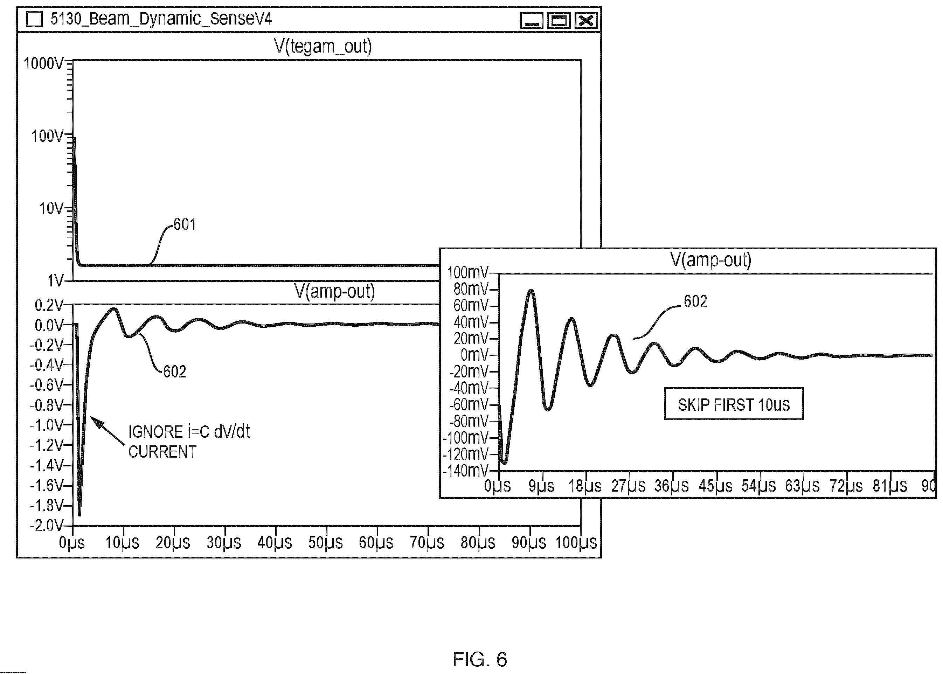

FIG. 6 shows an example oscilloscope readout 600 for the converted current to a voltage, according to an embodiment. The signal 601 is the gate signal, which can be seen going from 90V down to 2V as the gate signal is switched off. As the signal 601 is switched off, an induced voltage can be seen by voltage signal 602, which serves as a corollary to the resonant frequency of the cantilever beam circuit. In an embodiment, the data read from the oscilloscope may be used to estimate the pressure in a cavity, as the amount of gas in the cavity can be correlated to the damping ratio of the beam.

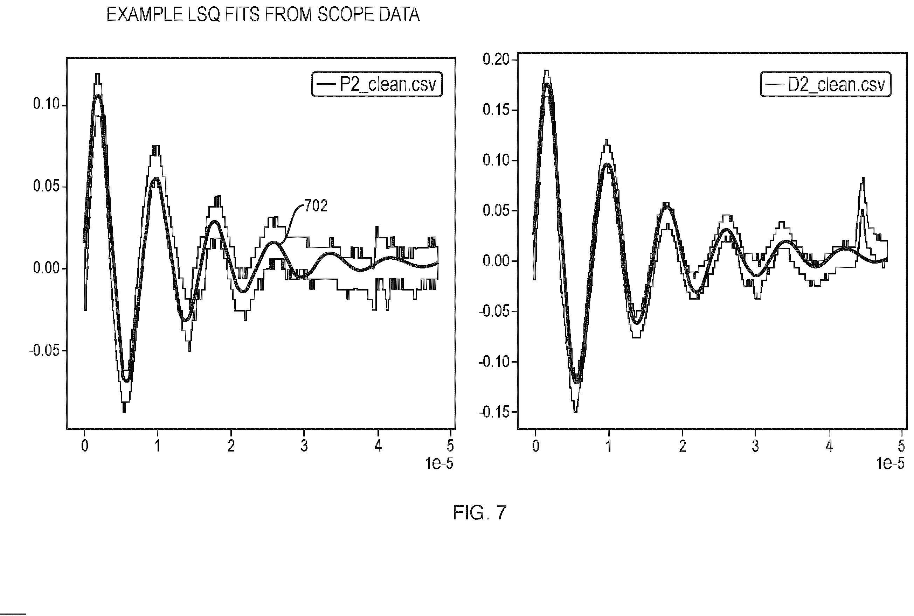

FIG. 7 is a readout of the least squares method (LSQ) fits from the oscilloscope data of FIG. 4, according to an embodiment. As shown, the oscilloscope data is fitted to a decaying sinusoid waveform 702. The frequency of the sinusoid waveform 702 is the resonant frequency of the beam of the MEMS switch 401.

## Gate Driver

The gate driver serves a dual purpose. The gate driver induces mechanical resonance in the beam by pulling the cantilever beam towards the gate using 90V, and then releasing the beam by dropping the supplied voltage to a lower voltage, e.g., 2V. The 2V signal provides a constant gate voltage while the beam is in motion, which allows for the generation of an electrical current based on the changing capacitance between the gate and the beam. Operational amplifiers may be used as the voltage supply to build this circuit, but other methods, like arbitrary wave form generators, may be used.

## Resistor or Transimpedance Amplifier

The resistor component may be used to convert the electrical current generated by the moving beam into a voltage signal. A transimpedance amplifier may be utilized for higher sensitivity and better signal-to-noise ratio compared to a simple resistor.

## Voltage Amplifier

The voltage amplifier amplifies the voltage signal from the resistor or transimpedance amplifier, allowing for easier visualization and analysis of the waveform on an oscilloscope.

## Oscilloscope

The oscilloscope captures and displays the amplified voltage waveform, which can be used to determine the dynamics of the MEMS switch cantilever beam. The data from the oscilloscope may be post processed using a, for example, Python script implemented on a personal computer, to extract the quantities of interest.

While example embodiments have been particularly shown and described, it will be understood that various changes in form and details may be made therein without departing from the scope of the embodiments encompassed by the appended claims.

Aspects of the present disclosure may be defined by the following clauses:

1. A test circuit structure for determining a dynamic of a beam of a micro-electrical-mechanical-system (MEMS) device comprising a gate electrode, a switch contact, and the beam, the test circuit structure comprising:

a voltage supply configured to sequentially produce (i) a switch-close voltage configured to bring the beam in contact with the switch contact, and (ii) a non-zero switch-open voltage configured to release the beam from contact with the switch contact and cause the MEMS switch to produce an oscillating current; a waveform capture device configured to determine the dynamic of the beam by an analysis of a waveform produced by the oscillating current upon release of the beam.

2. The test circuit structure of Clause 1, further comprising a resistor coupled to an output of the beam configured to convert the oscillating current to a voltage such that the voltage may be read by the waveform capture device.

3. The test circuit structure of Clause 1, wherein the voltage supply produces a high voltage to supply the switch-close voltage and produces a low voltage to supply the switch-open voltage.

4. The test circuit structure of Clause 3, wherein the high voltage is 90 volts or higher and the low voltage is 5 volts or lower.

5. The test circuit structure of Clause 1, further comprising a gate driver, wherein the gate driver: (i) induces mechanical resonance in the beam, and (ii) provides a constant voltage to the beam while the beam is in motion.

6. The test circuit structure of Clause 1, wherein the beam is a cantilever beam.

7. The test circuit structure of Clause 6, wherein the MEMS device further comprises:

> a first cantilever beam comprising a first gate electrode, and a first switch contact;
> a second cantilever beam comprising a second gate electrode and a second switch contact;
> the voltage supply configured to sequentially produce the switch close voltage and the switch open voltage to at least one of the first cantilever beam and the second cantilever beam;
> the oscillating current being produced in at least the first cantilever beam and the second cantilever beam;
> the waveform capture device configured to determine the dynamic of the MEMS switch by an analysis of either: (i) a waveform produced by the oscillating current of the first cantilever beam or the second cantilever beam upon beam release, or (ii) an average combined waveform produced by averaging the oscillating current of the first cantilever beam and the second cantilever beam upon beam release.

8. The test circuit structure of Clause 1, further comprising a transimpedance amplifier configured to convert the current into a voltage signal.

9. The test circuit structure of Clause 1, wherein the voltage supply induces mechanical resonance in the beam and provides a constant voltage to the gate electrode while the beam is in motion.

10. The test circuit structure of Clause 1, wherein the dynamic of the beam represents the resonant frequency, amplitude, damping ratio, phase shift, or any combination thereof.

11. A method of determining a dynamic of a beam in a micro-electro- mechanical-system (MEMS) device comprising a gate electrode, a switch contact, and a beam, the method comprising:
utilizing a MEMS switch that comprises a gate electrode, a switch contact and a beam,

> producing a switch-close voltage and a switch-open voltage by a voltage supply, the switch-open voltage bringing the beam in contact with the switch contact and the switch-open voltage releasing the beam from contact with the switch contact producing an oscillating current;
determining the dynamic of the beam by analyzing a waveform produced by the oscillating current upon beam release with a waveform capture device.

12. The method of Clause 11, wherein the voltage supply produces a high voltage to produce the switch-close voltage and produces a low voltage to produce the switch-open voltage.

13. The method of Clause 12, wherein the high voltage is 90 volts or higher and the low voltage is 5 volts or lower.

14. The method of Clause 11, wherein the waveform capture device is an oscilloscope, an analog to digital converter, or any combination thereof.

15. The method of Clause 11, wherein the dynamic of the beam represents the resonant frequency, amplitude, damping ratio, phase shift, or any combination thereof.

16. The method of Clause 11, further comprising a resistor coupled to an output of the beam configured to convert the oscillating current to a voltage such that the voltage may be read by the waveform capture device.

17. The method of Clause 11, further comprising a transimpedance amplifier configured to convert the current into a voltage signal.

18. The method of Clause 11, wherein the waveform capture device is an oscilloscope, an analog to digital converter, or any combination thereof.

19. The method of Clause 11, wherein the voltage supply induces mechanical resonance in the beam and provides a constant voltage to the gate while the beam is in a motion.

20. An apparatus for testing a micro-electrical-mechanical-system (MEMS) switch to determine a dynamic of a beam of the MEMS switch, comprising:

> a first voltage supply and a second voltage supply, the first voltage supply coupled to a first amplifier configured to set a voltage level, the second voltage supply coupled to a second amplifier configured to set a voltage offset;
> a first amplifier circuit configured to add the voltage level and the voltage offset;
> the MEMS switch comprising at least one gate electrode and the beam, the gate electrode coupled to an output of the first amplifier circuit;
> the beam coupled to an input of a second amplifier circuit configured to convert a current to a voltage, an output of the second amplifier circuit coupled to a waveform capture device configured to determine the dynamic of the MEMS switch beam.

## Claims

1.  A test circuit structure for determining a dynamic of a beam of a micro-electrical-mechanical-system (MEMS) device comprising a gate electrode, a switch contact, and the beam, the test circuit structure comprising:

    a voltage supply configured to sequentially produce (i) a switch-close voltage configured to bring the beam in contact with the switch contact, and (ii) a non-zero switch-open voltage configured to release the beam from contact with the switch contact and cause the MEMS switch to produce an oscillating current;
    a waveform capture device configured to determine the dynamic of the beam by an analysis of a waveform produced by the oscillating current upon release of the beam.

2.  The test circuit structure of claim 1, further comprising a resistor coupled to an output of the beam configured to convert the oscillating current to a voltage such that the voltage may be read by the waveform capture device.

3.  The test circuit structure of claim 1 or 2, wherein the voltage supply produces a high voltage to supply the switch-close voltage and produces a low voltage to supply the switch-open voltage, wherein the high voltage is 90 volts or higher and the low voltage is 5 volts or lower.

4.  The test circuit structure of any preceding claim, further comprising a gate driver, wherein the gate driver: (i) induces mechanical resonance in the beam, and (ii) provides a constant voltage to the beam while the beam is in motion.

5.  The test circuit structure of any preceding claim, wherein the beam is a cantilever beam.

6.  The test circuit structure of claim 5, wherein the MEMS device further comprises:

    a first cantilever beam comprising a first gate electrode, and a first switch contact;
    a second cantilever beam comprising a second gate electrode and a second switch contact;
    the voltage supply configured to sequentially produce the switch close voltage and the switch open voltage to at least one of the first cantilever beam and the second cantilever beam;
    the oscillating current being produced in at least the first cantilever beam and the second cantilever beam;
    the waveform capture device configured to determine the dynamic of the MEMS switch by an analysis of either: (i) a waveform produced by the oscillating current of the first cantilever beam or the second cantilever beam upon beam release, or (ii) an average combined waveform produced by averaging the oscillating current of the first cantilever beam and the second cantilever beam upon beam release.

7.  The test circuit structure of any preceding claim, further comprising a transimpedance amplifier configured to convert the current into a voltage signal.

8.  The test circuit structure of any preceding claim, wherein the voltage supply induces mechanical resonance in the beam and provides a constant voltage to the gate electrode while the beam is in motion.

9.  The test circuit structure of any preceding claim, wherein the dynamic of the beam represents the resonant frequency, amplitude, damping ratio, phase shift, or any combination thereof.

10.  A method of determining a dynamic of a beam in a micro-electro- mechanical-system (MEMS) device comprising a gate electrode, a switch contact, and a beam, the method comprising:

    utilizing a MEMS switch that comprises a gate electrode, a switch contact and a beam,
    producing a switch-close voltage and a switch-open voltage by a voltage supply, the switch-open voltage bringing the beam in contact with the switch contact and the switch-open voltage releasing the beam from contact with the switch contact producing an oscillating current;
    determining the dynamic of the beam by analyzing a waveform produced by the oscillating current upon beam release with a waveform capture device.

11.  The method of claim 10, wherein the voltage supply produces a high voltage to produce the switch-close voltage and produces a low voltage to produce the switch-open voltage, wherein the high voltage is 90 volts or higher and the low voltage is 5 volts or lower.

12.  The method of claim 10 or 11, wherein the waveform capture device is an oscilloscope, an analog to digital converter, or any combination thereof.

13.  The method of any of claims 10 to 12, wherein the dynamic of the beam represents the resonant frequency, amplitude, damping ratio, phase shift, or any combination thereof.

14.  The method of any of claims 10 to 13, further comprising a resistor coupled to an output of the beam configured to convert the oscillating current to a voltage such that the voltage may be read by the waveform capture device.

**15.** An apparatus for testing a micro-electrical-mechanical-system (MEMS) switch to determine a dynamic of a beam of the MEMS switch, comprising:

a first voltage supply and a second voltage supply, the first voltage supply coupled to a first amplifier configured to set a voltage level, the second voltage supply coupled to a second amplifier configured to set a voltage offset; a first amplifier circuit configured to add the voltage level and the voltage offset; the MEMS switch comprising at least one gate electrode and the beam, the gate electrode coupled to an output of the first amplifier circuit; the beam coupled to an input of a second amplifier circuit configured to convert a current to a voltage, an output of the second amplifier circuit coupled to a waveform capture device configured to determine the dynamic of the MEMS switch beam.

FIG. 1

EP 4 661 043 A1

200

A VOLTAGE SUPPLY CONFIGURED TO SEQUENTIALLY PRODUCE A SWITCH-CLOSE VOLTAGE CONFIGURED TO BRING THE BEAM IN CONTACT WITH THE SWITCH CONTACT, AND A NON-ZERO SWITCH-OPEN VOLTAGE CONFIGURED TO RELEASE THE BEAM FROM CONTACT WITH THE SWITCH CONTACT AND PRODUCE AN OSCILLATING CURRENT — 202

A WAVEFORM CAPTURE DEVICE CONFIGURED TO DETERMINE THE DYNAMIC OF THE MEMS SWITCH BY AN ANALYSIS OF A WAVEFORM PRODUCED BY THE OSCILLATING CURRENT UPON BEAM RELEASE — 203

FIG. 2

FIG. 3

400

401

403

MEMS SWITCH

GND

ic

Cbeam to gate

GATE

402

404

R3

R4

GND

407

406

OSCILLISCOPE

R2

2V

GND

R1

9V

GND

405

FIG. 4

FIG. 5

FIG. 6

EXAMPLE LSQ FITS FROM SCOPE DATA

FIG. 7

Europäisches
Patentamt

European
Patent Office

Office européen
des brevets

## EUROPEAN SEARCH REPORT

**Application Number**

EP 25 18 0580

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | Lin Yang: "Micromechanical Resonant Switches ("Resoswitches") and Resonant Power Converters", , 1 December 2015 (2015-12-01), pages 1-151, XP093319628, Retrieved from the Internet: URL:https://www2.eecs.berkeley.edu/Pubs/TechRpts/2015/EECS-2015-212.pdf * figures 1-1,2-7,2-11,2-12,2-15,2-17, 3-1, 3-10,3-114-16,4- * * pages 18-21 * * pages 24-30 * * pages 31-44 * ----- | 1-15 | INV. H01H11/00 H01H59/00 |
| X | Mercier D ET AL: "Monitoring mechanical characteristics of MEMS switches with a microwave test bench", 4th ESA Micro & Nano Technologies Round Table, 22 May 2003 (2003-05-22), pages 1-1, XP093318375, Retrieved from the Internet: URL:https://escies.org/download/webDocumentFile?id=1109 * the whole document * ----- -/-- | 1-15 | TECHNICAL FIELDS SEARCHED (IPC) H01H |

The present search report has been drawn up for all claims

| Place of search | Date of completion of the search | Examiner |
|---|---|---|
| Munich | 2 October 2025 | Bauer, Rodolphe |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.......................................................................................
& : member of the same patent family, corresponding document

EPO FORM 1503 03.82 (P04C01)

Europäisches
Patentamt

European
Patent Office

Office européen
des brevets

# EUROPEAN SEARCH REPORT

**Application Number**

EP 25 18 0580

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | KALICINSKI S ET AL: "A new method to determine the mechanical resonance frequency, quality factor and charging in electrostatically actuated MEMS", IEEE 21ST INTERNATIONAL CONFERENCE ON MICRO ELECTRO MECHANICAL SYSTEMS, 2008 : MEMS 2008 ; 13 - 17 JAN. 2008, TUCSON, ARIZONA, USA, PISCATAWAY, NJ : IEEE OPERATIONS CENTER, 1 January 2008 (2008-01-01), pages 653-656, XP031210831, DOI: 10.1109/MEMSYS.2008.4443741 ISBN: 978-1-4244-1792-6 * abstract; figures 1,3,4-8 * * 3. Results; page 654 - page 656 * | 1-15 | |
| X | VERGER A ET AL: "Nanogap MEMS micro-relay with 70 ns switching speed", MICRO ELECTRO MECHANICAL SYSTEMS (MEMS), 2012 IEEE 25TH INTERNATIONAL CONFERENCE ON, IEEE, 29 January 2012 (2012-01-29), pages 717-720, XP032137254, DOI: 10.1109/MEMSYS.2012.6170192 ISBN: 978-1-4673-0324-8 * the whole document * | 1-15 | TECHNICAL FIELDS SEARCHED (IPC) |
| A | MANINDER K ET AL: "On characterization of symmetric type capacitive RF MEMS switches", MICROSYSTEM TECHNOLOGIES, BERLIN, DE, vol. 25, no. 2, 25 June 2018 (2018-06-25), pages 729-734, XP036690490, ISSN: 0946-7076, DOI: 10.1007/S00542-018-4006-Z [retrieved on 2018-06-25] * page 733 - page 734; figure 9 * | 1-15 | |

-/--

The present search report has been drawn up for all claims

| Place of search | Date of completion of the search | Examiner |
|---|---|---|
| Munich | 2 October 2025 | Bauer, Rodolphe |

Europäisches
Patentamt

European
Patent Office

Office européen
des brevets

**EUROPEAN SEARCH REPORT**

Application Number

EP 25 18 0580

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | Anonymous: "Oscilloscope Measurement Lab Measuring Impedance and Capacitance with an Oscilloscope and Function Generator", , 24 April 2013 (2013-04-24), pages 1-5, XP093319751, Retrieved from the Internet: URL:https://download.tek.com/document/48W-29165-0%20Using%20an%20oscillocope%20and%20function%20generator%20to%20measure%20capacitor%204-24-2013%20DP.pdf * the whole document * ----- | 1-15 | |

TECHNICAL FIELDS
SEARCHED (IPC)

The present search report has been drawn up for all claims

| Place of search | Date of completion of the search | Examiner |
|---|---|---|
| Munich | 2 October 2025 | Bauer, Rodolphe |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 
& : member of the same patent family, corresponding document

EPO FORM 1503 03.82 (P04C01)